# EUROPEAN PATENT APPLICATION

(11) **EP 4 827 303 A1**
(43) Date of publication of application: **21.10.2026**
(21) Application number: 25863205.8
(22) Date of filing: 27.08.2025
(51) Int. Cl.: H10P 50/20

(54) **ETCHING GAS**

(30) Priority: 09.09.2024 JP 2024155079
(71) Applicant: DAIKIN INDUSTRIES, LTD., Osaka-shi, Osaka 530-0001 (JP)
(72) Inventor: ETO, Yusuke, Osaka-Shi, Osaka 530-0001 (JP); NAKAMURA, Shingo, Osaka-Shi, Osaka 530-0001 (JP); KUROKI, Yoshichika, Osaka-Shi, Osaka 530-0001 (JP); SUGIYAMA, Akinari, Osaka-Shi, Osaka 530-0001 (JP)
(74) Representative: Hoffmann Eitle
(86) International application number: PCT/JP2025/030033
(87) International publication number: WO 2026/053818

(57) **Abstract**

The present invention provides an etching gas comprising 1,1,1,2-tetrafluoroethane and a fluorocarbon-based compound with at least one double bond

## Description

### Technical Field

The present disclosure relates to an etching gas containing 1,1,1,2-tetrafluoroethane.

### Background Art

1,1,1,2-tetrafluoroethane is known as an etching gas,.

### Citation List

### Non Patent Literature

Non Patent Literature 1: Reactive Plasma Etching of SiC in a Tetrafluoroethane / Oxygen Plasma American Physical Society, Texas Section Fall, October 23-25, 2003, Texas Tech Campus, Lubbock Texas, MEETING ID: TSF03, abstract id. A5.008October 2003

### Summary of Invention

### Technical Problem

As an etching gas, 1,1,1,2-tetrafluoroethane is known, but the inventors have found that it has the problem of causing side etching. When the side etching occurs, it becomes difficult to obtain the desired processed shape.

An object of the present disclosure is to provide an etching gas containing 1,1,1,2-tetrafluoroethane that is less liable to cause side etching.

### Solution to Problem

The present disclosure includes the following aspects.
[Item 1]
   An etching gas containing 1,1,1,2-tetrafluoroethane and a fluorocarbon-based compound with at least one double bond.
[Item 2]
   The etching gas according to item 1, wherein the fluorocarbon-based compound with the double bond has one double bond.
[Item 3]
   The etching gas according to item 1 or 2, wherein the fluorocarbon-based compound with the double bond has 2 or 3 carbon atoms.
[Item 4]
   The etching gas according to any one of items 1 to 3, wherein the fluorocarbon-based compound with the double bond includes at least one compound selected from the group consisting of 1-chloro-1,2-difluoroethene, 1-chloro-1-fluoroethene, and 3,3,3-trifluoropropene.
[Item 5]
   The etching gas according to any one of items 1 to 4, wherein a concentration of the fluorocarbon-based compound with at least one double bond with respect to a total amount of 1,1,1,2-tetrafluoroethane and the fluorocarbon-based compound with at least one double bond is 1 ppm by volume or more and less than 400 ppm by volume.
[Item 6]
   The etching gas according to any one of items 1 to 5, wherein a concentration of the fluorocarbon-based compound with at least one double bond with respect to a total amount of 1,1,1,2-tetrafluoroethane and the fluorocarbon-based compound with at least one double bond is 50 ppm by volume or more and 300 ppm by volume or less.
[Item 7]
   The etching gas according to any one of items 1 to 6, further containing an inert gas.
[Item 8]
   The etching gas according to item 7, wherein the inert gas is argon.
[Item 9]
   The etching gas according to any one of items 1 to 8, wherein a concentration of 1,1,1,2-tetrafluoroethane in the etching gas is 1.0% by volume or more and 20% by volume or less.

### Advantageous Effects of Invention

According to the etching gas of the present disclosure, side etching is suppressed.

### Brief Description of Drawing

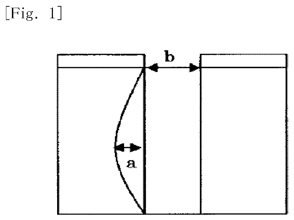

[Figure 1] Figure 1 is a schematic diagram illustrating a side etching ratio.

### Description of Embodiments

An etching gas of the present disclosure comprises 1,1,1,2-tetrafluoroethane, a fluorocarbon-based compound with at least one double bond, and an inert gas.

Adding a fluorocarbon-based compound with at least one double bond to a mixed gas containing 1,1,1,2-tetrafluoroethane allows suppression of side etching during etching, particularly hole etching.

The above fluorocarbon-based compound with the double bond is typically a hydrofluoroolefin (HFO).

Examples of the hydrofluoroolefin (HFO) include 2-chloro-1,1-difluoroethene (HFO-1122), (E/Z)1-chloro-1,2-difluoroethene (HFO-1122a), trifluoroethene (HFO-1123), 1-chloro-2-fluoroethene (HFO-1131), 2,3,3,3-tetrafluoropropene (HFO-1234yf), 3,3,3-trifluoropropene (HFO-1243zf), trans-1,3,3,3-tetrafluoropropene (HFO-1234ze), 1,3,3,3-tetrafluoropropene (HFO-1234zd), and 1,2,3,3,3-pentafluoropropene (HFO-1336mzz).

In one aspect, the fluorocarbon-based compound with the double bond has one double bond.

In one aspect, the fluorocarbon-based compound with the double bond has 2 or 3 carbon atoms.

In a preferable aspect, the fluorocarbon-based compound with the double bond includes at least one compound selected from the group consisting of 1-chloro-1,2-difluoroethene, 1-chloro-2-fluoroethene, and 3,3,3-trifluoropropene. The fluorocarbon-based compound with the double bond is preferably 1-chloro-1,2-difluoroethene, 1-chloro-2-fluoroethene, and 3,3,3-trifluoropropene. The fluorocarbon-based compound with the double bond may be used alone or in combination of two or more.

A concentration of the fluorocarbon-based compound with the double bond with respect to a total amount of 1,1,1,2-tetrafluoroethane and the fluorocarbon-based compounds with at least one double bond can be 1 ppm by volume or more, preferably 5 ppm by volume or more, more preferably 10 ppm by volume or more, even more preferably 50 ppm by volume or more, for example, 100 ppm by volume or more. By containing 1 ppm by volume or more of the fluorocarbon-based compound with the double bond allows to suppress side etching. In addition, the concentration of the above fluorocarbon-based compound with the double bond can be less than 500 ppm by volume, preferably 400 ppm by volume or less, more preferably 300 ppm by volume or less, for example, 200 ppm by volume or less or 100 ppm by volume or less. Setting the concentration of the fluorocarbon-based compound with the double bond to less than 500 ppm by volume allows to suppress hole clogging during etching. The concentration of the above fluorocarbon-based compound with the double bond can be 1 ppm by volume or more and less than 500 ppm by volume, preferably 5 to 400 ppm by volume, and more preferably 50 to 300 ppm by volume.

The etching gas of the present disclosure may contain an inert gas. The inert gas is used as a so-called dilution gas.

The inert gas is not particularly limited as long as it is inert to 1,1,1,2-tetrafluoroethane and the fluorocarbon-based compound with the double bond. The inert gas is, for example, nitrogen or a noble gas. The noble gas is helium, neon, argon, xenon, and krypton. The inert gas is preferably argon. The inert gas may be used alone or in combination of two or more.

The etching gas of the present disclosure may contain an additive gas.

Examples of the additive gas include oxygen and hydrogen.

A concentration of oxygen in the etching gas can be, for example, 1.0 to 20% by volume, preferably 2.0 to 10% by volume, and more preferably 2.0 to 5.0% by volume. The amount of oxygen used is preferably 50 to 150% of the amount of 1,1,1,2-tetrafluoroethane, more preferably 80 to 120%, for example, an equal amount.

A concentration of hydrogen in the etching gas can be, for example, 0.1 to 10% by volume, preferably 0.1 to 1.0% by volume, and more preferably 0.1 to 0.50% by volume. The amount of hydrogen used is preferably 10 to 20% of the amount of 1,1,1,2-tetrafluoroethane.

A concentration of 1,1,1,2-tetrafluoroethane in the etching gas is preferably 1.0 to 20% by volume, and more preferably 1.0 to 20% by volume.

The etching gas of the present disclosure is suitably used for dry etching.

The etching gas of the present disclosure can etch a variety of substrates. Examples of the substrates include SiO₂ and SiN.

### (Etching Method)

Etching using the etching gas of the present disclosure can be performed using conventional etching methods, preferably dry etching methods. In addition, the etching conditions may be as follows, for example:
- Flow rate: 5 to 500 sccm, preferably 10 to 300 sccm;
- Discharge power: 200 to 1,000 W, preferably 300 to 600 W;
- Bias power: 10 to 2,000 W, preferably 100 to 1,000 W;
- Pressure (gauge pressure): 30 mTorr or less (3.99 Pa or less), preferably 2 to 10 mTorr (0.266 to 1.33 Pa);
- Electron density: 10⁹ to 10¹³ cm⁻³, preferably 10¹⁰ to 10¹² cm⁻³;
- Electron temperature: 2 to 9 eV, preferably 3 to 8 eV;
- Wafer temperature: -40 to 100°C, preferably -30 to 50°C;
- Chamber wall temperature: -30 to 300°C, preferably 20 to 200°C.

### Examples

Hereinafter, the etching gas of the present disclosure will be described more specifically with reference to the following Examples, but the present disclosure is not limited to these Examples.

Mixed gases containing 1,1,1,2-tetrafluoroethane and a fluorocarbon-based compound, in which the fluorocarbon-based compound was contained at the amount shown in the following table were prepared. The fluorocarbon-based compounds used were 1-chloro-1,2-difluoroethene (HFO-1122a), 1-chloro-2-fluoroethene (HFO-1131), and 3,3,3-trifluoropropene (HFO-1243zf). Here, the mixed gas 0 contained only 1,1,1,2-tetrafluoroethane and no fluorocarbon-based compound.

**[Table 1]**

| | Fluorocarbon-based compound (ppm by volume) | | |
|---|---|---|---|
| | 1122a | 1243zf | 1131 |
| Mixed gas 0 | - | - | - |
| Mixed gas 1 | 5 | - | - |
| Mixed gas 2 | 100 | - | - |
| Mixed gas 3 | 200 | - | - |
| Mixed gas 4 | 500 | - | - |
| Mixed gas 5 | - | 50 | - |
| Mixed gas 6 | - | 100 | - |
| Mixed gas 7 | - | 300 | - |
| Mixed gas 8 | - | 500 | - |
| Mixed gas 9 | - | - | 50 |
| Mixed gas 10 | - | - | 100 |
| Mixed gas 11 | - | - | 300 |
| Mixed gas 12 | - | - | 500 |

SiO₂ and SiN films on silicon wafers were etched using the above mixed gases 1 to 12 and the comparative gas. Specifically, the mixed gas and the additive gas were introduced through a gas inlet connected to an upper electrode, and the process gas was excited by a highfrequency power supply (13.56 MHz, 0.22 W) to perform the etching. The film thickness was 100 µm. The flow rates of the gases are shown in the following Table.

After etching, cross-section of the silicon wafers were observed using SEM, to obtain side etching ratios. Relative ratios of the side etching ratios with respect to Comparative Example are shown in the following Table. Here, the side etching ratio R is a ratio of a side etching amount, a, to a hole diameter, b, shown in Figure 1 and is calculated using the following formula. $R = a / b$

**[Table 2]**

| | Film type | Gas used | Flow rate (ccm) | | | | Side etching ratio (to Comparative Example) |
|---|---|---|---|---|---|---|---|
| | | | Mixed gas | Oxygen | Ar | Hydrogen | |
| Comparative Example 1 | SiO₂ | 0 | 15 | 15 | 200 | 0 | 1 |
| Example 1 | SiO₂ | 1 | 15 | 15 | 200 | 0 | 0.92 |
| Example 2 | SiO₂ | 2 | 15 | 15 | 200 | 0 | 0.84 |
| Example 3 | SiO₂ | 3 | 15 | 15 | 200 | 0 | 0.75 |
| Comparative Example 2 | SiO₂ | 4 | 15 | 15 | 200 | 0 | Hole clogging |
| Comparative Example 3 | SiN | 0 | 15 | 15 | 200 | 3 | 1 |
| Example 4 | SiN | 1 | 15 | 15 | 200 | 3 | 0.93 |
| Example 5 | SiN | 2 | 15 | 15 | 200 | 3 | 0.89 |
| Example 6 | SiN | 3 | 15 | 15 | 200 | 3 | 0.81 |
| Comparative Example 4 | SiN | 4 | 15 | 15 | 200 | 3 | Hole clogging |
| Comparative Example 5 | SiO₂ | 0 | 10 | 10 | 250 | 0 | 1 |
| Example 7 | SiO₂ | 5 | 10 | 10 | 250 | 0 | 0.96 |
| Example 8 | SiO₂ | 6 | 10 | 10 | 250 | 0 | 0.88 |
| Example 9 | SiO₂ | 7 | 10 | 10 | 250 | 0 | 0.85 |
| Comparative Example 6 | SiO₂ | 8 | 10 | 10 | 250 | 0 | Hole clogging |
| Comparative Example 7 | SiN | 0 | 10 | 10 | 250 | 1 | 1 |
| Example 10 | SiN | 5 | 10 | 10 | 250 | 1 | 0.96 |
| Example 11 | SiN | 6 | 10 | 10 | 250 | 1 | 0.89 |
| Example 12 | SiN | 7 | 10 | 10 | 250 | 1 | 0.84 |
| Comparative Example 8 | SiN | 8 | 10 | 10 | 250 | 1 | Hole clogging |
| Comparative Example 9 | SiO₂ | 0 | 10 | 10 | 250 | 0 | 1 |
| Example 13 | SiO₂ | 9 | 10 | 10 | 250 | 0 | 0.96 |
| Example 14 | SiO₂ | 10 | 10 | 10 | 250 | 0 | 0.92 |
| Example 15 | SiO₂ | 11 | 10 | 10 | 250 | 0 | 0.91 |
| Comparative Example 10 | SiO₂ | 12 | 10 | 10 | 250 | 0 | Hole clogging |
| Comparative Example 11 | SiN | 0 | 10 | 10 | 250 | 2 | 1 |
| Example 16 | SiN | 9 | 10 | 10 | 250 | 2 | 0.95 |
| Example 17 | SiN | 10 | 10 | 10 | 250 | 2 | 0.92 |
| Example 18 | SiN | 11 | 10 | 10 | 250 | 2 | 0.91 |
| Comparative Example 12 | SiN | 12 | 10 | 10 | 250 | 2 | Hole clogging |

### Industrial Applicability

The etching gas of the present disclosure is suitable for use in fields requiring more precise etching, such as a field of semiconductor.

## Claims

1. An etching gas comprising 1,1,1,2-tetrafluoroethane and a fluorocarbon-based compound with at least one double bond.

2. The etching gas according to claim 1, wherein the fluorocarbon-based compound with the double bond has one double bond.

3. The etching gas according to claim 1 or 2, wherein the fluorocarbon-based compound with the double bond has 2 or 3 carbon atoms.

4. The etching gas according to any one of claims 1 to 3, wherein the fluorocarbon-based compound with the double bond comprises at least one compound selected from the group consisting of 1-chloro-1,2-difluoroethene, 1-chloro-1-fluoroethene, and 3,3,3-trifluoropropene.

5. The etching gas according to any one of claims 1 to 4, wherein a concentration of the fluorocarbon-based compound with at least one double bond with respect to a total amount of 1,1,1,2-tetrafluoroethane and the fluorocarbon-based compound with at least one double bond is 1 ppm by volume or more and less than 400 ppm by volume.

6. The etching gas according to any one of claims 1 to 5, wherein a concentration of the fluorocarbon-based compound with at least one double bond with respect to a total amount of 1,1,1,2-tetrafluoroethane and the fluorocarbon-based compound with at least one double bond is 50 ppm by volume or more and 300 ppm by volume or less.

7. The etching gas according to any one of claims 1 to 6, further comprising an inert gas.

8. The etching gas according to claim 7, wherein the inert gas is argon.

9. The etching gas according to any one of claims 1 to 8, wherein a concentration of 1,1,1,2-tetrafluoroethane in the etching gas is 1.0% by volume or more and 20% by volume or less.
